## Europäisches Patentamt
## European Patent Office
## Office européen des brevets

(11) Publication number: **0 104 741**
**B1**

# EUROPEAN PATENT SPECIFICATION

(45) Date of publication of patent specification: **25.07.90**

(21) Application number: **83304750.9**

(22) Date of filing: **17.08.83**

(51) Int. Cl.⁵: **C 30 B 11/00, C 30 B 35/00, C 30 B 27/02, C 30 B 13/14**

(54) Process for growing crystalline material.

(30) Priority: **23.08.82 US 410452**

(43) Date of publication of application:
**04.04.84 Bulletin 84/14**

(45) Publication of the grant of the patent:
**25.07.90 Bulletin 90/30**

(84) Designated Contracting States:
**BE DE FR IT NL**

(56) References cited:
**EP-A-0 010 307**
**DE-A-1 959 392**
**DE-A-2 361 868**

**The file contains technical information submitted after the application was filed and not included in this specification**

(73) Proprietor: **Western Electric Company, Incorporated**
**222 Broadway**
**New York, NY 10038 (US)**

(72) Inventor: **Geyling, Franz Thomas**
**Post House Road**
**Morristown New Jersey 07960 (US)**
Inventor: **Von Neida, Allyn Robert**
**133 Ashland Road**
**Summit New Jersey 07901 (US)**
Inventor: **Young, Morris Shen-Shih**
**780 Mountain Avenue**
**Berkeley Heights New Jersey 07922 (US)**

(74) Representative: **Watts, Christopher Malcolm Kelway et al**
**AT&T (UK) LTD. AT&T Intellectual Property Division 5 Mornington Road**
**Woodford Green Essex IG8 OTU (GB)**

Courier Press, Leamington Spa, England.

**Description**

The invention relates to processes for growing crystalline material by crystal growth techniques involving cooling a melt in a container until the melt solidifies into crystalline material in the container.

One of the most interesting and commercially significant developments in recent years in the semiconductor area is the increasing importance and use of compound semiconductors. Particularly significant commercially are the III—V semiconductor compounds such as GaAs, InP, etc. Compound semiconductors are used in a variety of devices including semiconductor lasers, light emitting diodes, microwave oscillators and amplifiers and various types of detectors including infrared and visible light detectors. Increasingly, in recent years, various semiconductor compounds are being considered for memory and logic circuits because higher electron mobilities in some compound semiconductors make possible reduced access times compared to silicon circuits.

A large variety of compound semiconductors are known including for example, GaP, InP, BP, AlP, GaAs, InAs, AlAs, AlSb, GaSb, InSb, InBi, etc. Many have highly attractive properties such as high mobility and low effective mass.

One of the prime difficulties in working with many of these compound semiconductors including both III—V and II—V compounds is the production of large, high purity, high quality crystals. Many of the difficulties in obtaining suitable crystals for use in devices are associated with the fact that the compound semiconductor decomposes at the melting point with the release of the more volatile component. Thus, growth of these crystals must take place under pressure so that the more volatile component is maintained in stoichiometric composition in the melt. Often, this requires some kind of closed system with some of the components of the compound semiconductor under pressure. Another difficulty often aggravated by the difficulty mentioned above is the extreme reactivity of many of the constituent elements. For example, aluminium, arsenic and phosphorus, particularly at high temperatures, are highly reactive. Such reactivity often requires the use of special crucibles and, in particular, the use of special component parts so as to preclude reaction with these highly active elements. Such reactivity often leads to unwanted impurities in the crystal which limit the usefulness of the semiconductor compound and lead to high rejection rates for grown crystals. In addition, some of the semiconductor compounds which are of particular industrial importance have high melting points. By itself, this is not a serious problem, but in conjunction with the other two problems mentioned above it often leads to considerable difficulty. Another severe difficulty arises from the fact that these semiconductor compounds expand upon freezing. Such expansion on freezing often introduces severe straining and dislocation in the crystals which limits their quality and usefulness in device applications. Many of the growth problems and growth techniques used in making monocrystalline semiconductor compounds have been outlined in an article by L. R. Weisberg in the book *The Art and Science of Growing Crystals* edited by J. J. Gilman, John Wiley and Sons, New York, 1963, Chapter 19, pages 381—387.

A variety of techniques have been used to make crystalline semiconductor compounds, including zone refining and various types of crystal pulling. Some of these techniques have been discussed in detail in an article entitled "Growth of Single Crystals of GaAs in Bulk and Thin Film Form" by B. A. Joyce contained in the book *Crystal Growth* edited by Brian R. Pamplin, Pergamon Press, New York, Chapter 5. Particularly noteworthy in this artcle is growth by liquid encapsulation. In this method, the melt is covered completely with an inert liquid. The inert liquid is kept in place by use of an inert gas over liquid. The pressure of the inert gas is maintained sufficiently high so as to overcome the dissociation pressure of the more volatile component in the melt.

Because of the industrial importance of many semiconductor compounds, it is highly desirable to have a reliable, reproducible, rapid procedure for growing high quality, high purity crystals of these semiconductor compounds with low detect densities and low strain.

A process as set out in the preamble of the main claim is known from DE—A—1959392. A crystal of gallium arsenide is grown in a boron nitride boat contained within a quartz ampoule. Neither the melt nor the crystal come into contact with the quartz ampoule during the process, but only with the boat. To prevent transport of silicon from the quartz ampoule to the crystal via the gas phase, however, a layer of boron nitride is formed on the inner surface of the ampoule.

With the invention as claimed the layer of interposed substance prevents adhesion between the crystal and the container, thereby reducing the strain which the crystal undergoes and thus improving its quality.

The procedure applied to a variety of crystal growth techniques all of which involve solidification of the melt while held in a container, often by use of a temperature gradient. Particular crystal growing techniques include the horizontal Bridgeman technique, the horizontal gradient freeze technique, and the vertical Bridgeman technique.

The encapsulating substance between semiconductor compound and container insures low defect density and low strain as well as minimum contamination from the container. Also, it often permits use of container materials which would ordinarily be prohibited because of reactivity with the semiconductor compounds or its elements.

Some embodiments of the invention will be described by way of example with reference to the accompanying drawings in which:

Fig. 1 shows a schematic diagram of a horizontal Bridgman crystal growth apparatus in which the furnace moves down the length of the boat containing the crystal melt for carrying out a process according to the invention;

Fig. 2 shows a schematic diagram of a horizontal Bridgman crystal growth apparatus in which the sample is moved along the length of the furnace for carrying out a process according to the invention;

Fig. 3 shows a schematic diagram of a gradient temperature control apparatus for growing crystals by a process according to the invention;

Fig. 4 shows a diagram of a gradient freeze crystal growth apparatus particularly suited for growth of GaAs by a process according to the invention; and

Fig. 5 shows a diagram of a vertical gradient freeze crystal growing apparatus particularly suited for growth of GaAs by a process according to the invention.

Various amounts of another substance may be added to the boron oxide to adjust various properties of the boron oxide (generally to lower viscosity).

The added substance again should preferably be chemically inert to and insoluble in the compound being grown and its elements. If not inert or insoluble, any contamination of the semiconductor compound by the encapsulating substance should not be detrimental to the properties (especially semiconducting properties) of the crystalline semiconducting compound. A typical substance for lowering viscosity is sodium aluminium fluoride ($Na_3AlF_6$), often called cryolite. Small amounts of dopants and other additives may be used. Usually dopant concentration is well below one mole percent and additives usually less than about 5 mole percent.

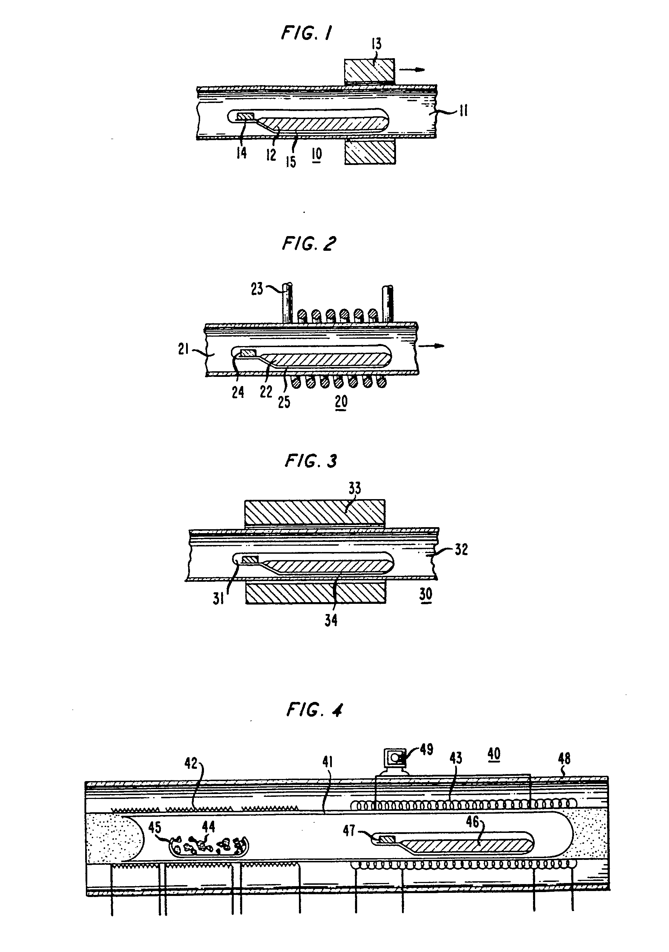

A number of growth techniques are illustrated in the figures. Fig. 1 shows a horizontal Bridgman apparatus *10* with a growth vessel 11 and boat 12 or container. Often, the vessel 11 is sealed in the growth of semiconductor compounds to prevent the evaporation of one of the elements and maintain steady state conditions. In this apparatus, the heater 13 is moved along the vessel 11 so as to create the necessary temperature gradient for solidifying the melt. A seed crystal 14 is used to initiate crystal growth. The encapsulating substance 15 is contained in the boat between the melt of the crystal being grown and the boat.

Fig. 2 shows a similar apparatus *20* with vessel 21 and boat 22 in which the vessel 21 is moved through the heater 23 to change the temperature at the boat. A seed crystal 24 may be used to initiate crystal growth in a particular crystallographic orientation. Again, the encapsulating substance 25 is contained in the boat between the melt of the crystal being grown and the boat.

Fig. 3 shows another type of apparatus, generally called a gradient temperature apparatus *30* in which the container or boat 31, often located inside a sealed vessel 32, is located inside a heater 33. Here, the vessel does not move but the temperature gradient is achieved by heater design and reducing the energy supplied to the heater. The heater is designed so that the temperature varies along the long axis of the boat (generally increases from one end where the seed is located to the other). The temperature is set so that the entire sample melts and then energy to the heater is decreased. In this way, the melt first freezes at one point in the boat (e.g., the end with the seed) and continues to freeze along the boat as energy to the heater is decreased. Typically, the heater is an electrical heater and energy is controlled by controlling the current or voltage to the heater. Again, the encapsulating substance 34 is contained in the boat between boat and the melt of the crystal being grown.

Fig. 1 and 2 show apparatus generally used in the horizontal Bridgman technique. Fig. 3 shows apparatus usually used in the gradient freeze technique. Other crystal growth techniques involve use of similar apparatus placed in the vertical direction. Often, the vessel rather than a boat is used to hold the melt. These procedures are often called the vertical Bridgman technique and the vertical gradient freeze technique. Again, the vessel is often sealed to prevent escape of a volatile component and to maintain stable conditions. Seeds are often used to insure proper growth of single crystals. Seeds may be used from the top or bottom.

One particular variant of the vertical gradient freeze technique is of great interest in the growth of GaAs and similar crystals. In this technique, the melt is contained in a crucible and the temperature is decreased to solidify the melt. Again, the encapsulating substance between crucible and melt prevents interaction between crucible and melt and insures easy removal of the crystal from the crucible after solidification of the melt. The melt is often seeded with a crystal to induce growth in a particular crystallographic direction. Often, this seeding operation is carried out by lowering a crystal of suitable orientation into the top of the melt.

The solidified crystal is removed from the crucible at a temperature above room temperature, before the encapsulating substance solidifies or becomes too hard to allow for easy crystal removal. For example, where $B_2O_3$ is used, the crystal is removed above about 650 degrees C. The temperature at which the crystal is removed is not critical and generally depends on the crystal being grown and the encapsulating substance. It should be below the solidification temperature of the crystal being grown but above the temperature at which the encapsulating substance becomes hard and adheres to container and crystal.

A better understanding of the invention may be obtained by a detailed description of some examples of crystal growth using the lubricating layer in the container. Gallium arsenide is an extremely difficult crystal to grow consistently in large size, with low defect density and low contamination. The difficulty arises from the high volatility of the elements making up the gallium arsenide, especially the arsenic, the high growth temperature and the reactivity of the elements with the container at these high temperatures.

Experiments were carried out in the experimental apparatus shown in Fig. 4. The apparatus 40 is a gradient freeze furnace particularly suitable for growing gallium aresenide and other similar semiconductor compounds. The apparatus is shown with the charge in place ready for crystal growth. Here, the gallium arsenide melt is actually made in the apparatus prior to crystal growth.

The gradient freeze apparatus 40 is made up of a long vessel 41 usually made of a transparent material such as quartz. The vessel is divided into two regions, a low temperature region supplied with heater wires 42 and a high temperature region supplied with another set of heater wires 43. The arsenic 44 is held in a container 45 usually made of quartz and gallium 46 is contained in a boat usually made of quartz or pyrolytic boron nitride. A seed crystal of gallium arsenide 47 is contained in the boat so as to initiate growth of the crystal in a desired crystallographic direction. The vessel 41 is surrounded by insulating material 48 and the apparatus is equipped with a viewing window 49 to observe growth of the crystal.

In a typical growth procedure for gallium arsenide, the low temperature region is heated to about 610—630 degrees C and the high temperature region to a temperature range from about 1238 degrees C at the seed to about 1290 degrees C at the other end of the boat. Arsenic 44 distilled over from the arsenic container 45 reacts with the gallium in the boat to form gallium arsenide melt. The temperature in the high temperature section is slowly lowered so as to initiate crystal growth at the seed and the temperature slowly lowered to complete solidification of the melt. Typically, crystal growth is at a rate of about 6 to 13 mm (1/4 to 1/2 inch) per hour although slower an more rapid growth is easily achievable.

A number of experiments were carried out as described above with the following results.

Example 1:
This experiment was carried out with 307 grammes of arsenic of 281.9 grammes of gallium. The seed crystal orientation was <111> and 16 grammes of $B_2O_3$ were used as encapsulating substance. The dopant was silicon (0.203 grammes), growth rate of about 13 mm (1/2 inch) per hour and a quartz boat was used. Excellent results were obtained. The crystal obtained was of excellent quality with an etch pit density (EPD) of 1000 per square centimetre. The EPD was obtained by etching a polished {100} surface in molten KOH at 325 degrees C for 1 to 1.5 hours.

Example 2:
This experiment was the same as above but with 348.3 grammes of arsenic, 320.1 grammes of gallium, seed orientation of <111> and 15 grammes of $B_2O_3$. About 0.232 grammes of silicon were used as dopant, growth rate was 13 mm (1/2 inch) per hour and a quartz boat was used to contain the melt. A single crystal of excellent quality was obtained with an EPD of 2000 per square conteimetre.

Example 3
This experiment was the same as above but with 466.6 grammes of arsenic, 430 grammes of gallium, seed orientation of <111> and 15 grammes of $B_2O_3$. About 0.313 grammes of silicon were used as dopant, growth rate was 13 mm (1/2 inch) per hour and a quartz boat was used to contain the melt. A single crystal of excellent quality was obtained with an EPD of 2000 per square centimetre.

Example 4:
This experiment was the same as above but with 447 grammes of arsenic, 410 grammes of gallium, seed orientation of <100>, and 14 grammes of $B_2O_3$. About 0.299 grammes of silicon were used as dopant, growth rate was 13 mm (1/2 inch) per hour and a quartz boat was used to contain the melt. A single crystal of excellent quality was obtained with an EPD of 3000 per square centimetre.

Example 5:
This experiment was the same as above but with 433.5 grammes of arsenic, 397 grammes of gallium, seed orientation of <111> and 7 grammes of $B_2O_3$. About 0.29 grammes of silicon were used as dopant, growth rate was 8 mm (1/3 inch) per hour and a quartz boat was used to contain the melt. A single crystal of excellent quality was obtained with an EPD of 800 per square centimetre.

Example 6:
This experiment was the same as above but with 444 grammes of arsenic, 440 grammes of gallium, seed orientation of <111> and 14 grammes of $B_2O_3$. About 0.149 grammes of silicon were used as dopant, growth rate was 6 mm (1/4 inch) per hour and a PBN (pyrolytic boron nitride) boat was used to contain the melt. A single crystal of excellent quality was obtained with an EPD of 8000 per square centimetre.

Example 7:
This experiment was the same as above but with 175 grammes of arsenic, 435 grammes of gallium, seed orientation of <111> and 14 grammes of $B_2O_3$. No silicon was used as dopant, the growth rate was 13 mm (1/2 inch) per hour, and a quartz boat was used to contain the melt. A single crystal of excellent quality was obtained with an EPD of 600 per square centimetre.

Several points about these experiments are worth noting. First, crystal growth along the <100> crystal orientation was possible which is highly advantageous for many applications. Indeed, excellent control of the conditions under which the crystal grows makes possible crystal growth along a variety of crystallographic directions. The amount of dopant and impurities in the crystal is much reduced and more predictable because the encapsulating substance separated the melt from the boat. The boat is often a potential source of dopant and impurities. Also, PBN can be used as a boat material which greatly reduces the chances of contamination from the boat material. Typical amounts of $B_2O_3$ may vary over large limits.

The crystal in the boat is removed before complete cooling (often about 650 degrees C) to avoid sticking after the $B_2O_3$ becomes hard. This can be accomplished by rocking the boat onto its side and allowing the already formed crystal to partially fall out of the boat. This procedure can be accompanied by thermal cycling (in the temperature range from about 1000 to 1200 degrees C) to release any part of the crystal adhering to the boat or encapsulating substance. Other methods may be used including removal of the $B_2O_3$ by chemical means.

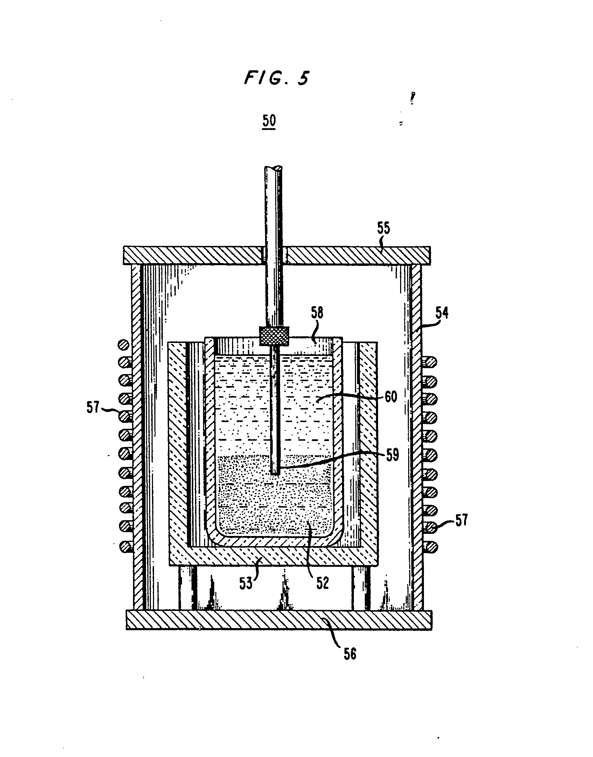

Experiments were also carried out in a vertical gradient freezing apparatus 50 shown in Fig. 5. Here, the gallium aresenide 51 is contained in a quartz crucible 52, and this crucible contained in a structure 53 conveniently made of foamed aluminium oxides. This entire structure is contained inside a furnace structure conveniently made from a quartz cylinder 54, a top 55 made of stainless steel and bottom 56 made of stainless steel. The structure is heated from induction coils 57 and a carbon sleeve 58 surrounds the quartz crucible 52 to absorb the radio frequency energy. A seed crystal 59 is used to initiate growth of the crystal and the top of the gallium arsenide melt contains a layer of boron oxide 60 which separates the melt from the crucible 52.

The temperature gradient is in the vertical direction with the lowest temperature of the gallium arsenide at the interface between boron oxide and gallium arsenide. The temperature at this interface is usually slightly over the melting point for gallium arsenide (1238 degrees C) at the beginning of the growth procedure. The temperature gradient running down the gallium arsenide melt may vary over large limits, but is generally between 8 and 80 degrees C per cm (20 and 200 per inch). This gradient may be changed by altering the initial distribution within the apparatus and by increasing the thickness of the $B_2O_3$. The temperature is slowly lowered so as to affect crystal growth down through the gallium arsenide melt. After complete solidification but before cooling to room temperature (usually in the temperature range between 650 and 1150 degrees C), the crystal is removed from the crucible. The presence of the $B_2O_3$, particularly on the side walls and bottom of the crucible, permits easy removal of the crystal. Crystals grown by this procedure were quite large with large volume of high quality. A particular advantage of crystals grown by this method is the large volume and the large cross sections obtained.

A particular example might be useful in illustrating the process. A silica crucible was loaded with 800 grammes of galldium arsenide and 400 grammes of boron oxide. The crucible with charge was heated to above the melting point of gallium arsenide and slowly cooled with a temperature gradient as described above. After solidification but before cooling below about 1000 degrees C, the gallium arsenide crystal was extracted from the crucible using quartz rods frozen into the crystal at the outer edges. The diameter of the crystal was about 7.5 cm (three inches). The crystal was largely single crystal with some polycrystalline regions near the edges. The crystal weighed about 775 grammes.

## Claims

1. A process for growing a single crystal of gallium arsenide or indium phosphide by a crystal growth technique involving solidifying a melt in a container (12, 22, 52) into a crystalline material, characterized in that an inert material (15, 25, 60) comprising boron oxide is interposed, prior to said solidifying step, between the container and the melt.

2. A process as claimed in claim 1, wherein the inert substance comprises, in addition to boron oxide, sodium aluminium fluoride.

3. A process as claimed in claim 1 or claim 2, wherein the semiconductor compound is gallium arsenide.

4. A process as claimed in claim 1 or claim 2, wherein the semiconductor compound is indium phosphide.

5. A process as claimed in any of the preceding claims, wherein the container is of quartz.

6. A process as claimed in any of claims 1 to 4 wherein the container is of boron nitride.

## Patentansprüche

1. Verfahren zum Züchten eines Galliumarsenid- oder Indiumphosphid-Einkristalles durch ein Kristallzüchtungsverfahren, bei dem man eine Schmelze in einem Behälter (12, 22, 52) zu einem kristallinen Material erstarren läßt, dadurch gekennzeichnet, daß

—ein ein Boroxid umfassendes Inertmaterial (15, 25, 60) vor dem Erstarrungsschritt zwischen Behälter und Schmelze angeordnet wird.

2. Verfahren wie in Anspruch 1 beansprucht, bei dem die Inertsubstanz Natriumaluminiumfluorid zusätzlich zu Boroxid umfaßt.

3. Verfahren wie in Anspruch 1 oder 2 beansprucht, bei dem die Halbleiterverbindung Galliumarsenid ist.

4. Verfahren nach wie in Anspruch 1 oder 2, beansprucht, bei dem die Halbleiterverbindung Indiumphosphid ist.

5. Verfahren wie in einem der vorstehenden Ansprüche beansprucht, bei dem der Behälter aus Quarz ist.

6. Verfahren wie in einem der Ansprüche 1 bis 4 beansprucht, bei dem der Behälter aus Bornitrid ist.

**Revendications**

1. Un procédé de croissance d'un monocristal d'arséniure de gallium ou de phosphure d'indium par une technique de croissance de cristal faisant intervenir la solidification d'un bain en fusion dans un creuset (12, 22, 52) pour donner un matériau cristallin, caractérisé en ce qu'on interpose entre le creuset et le bain en fusion, avant l'étape de solidification, un matériau inerte (15, 25, 60) qui comprend de l'oxyde de bore.

2. Un procédé selon la revendication 1, dans lequel la substance inerte comprend, en plus de l'oxyde de bore, de fluorure de sodium-aluminium.

3. Un procédé selon la revendication 1 ou la revendication 2, dans lequelle le composé semiconducteur est de l'arséniure de gallium.

4. Un procédé selon la revendication 1 ou la revendication 2, dans lequel le composé semiconducteur est du phosphure d'indium.

5. Un procédé selon l'une quelconque des revendications précédentes, dans lequel le creuset est en quartz.

6. Un procédé selon l'une quelconque des revendications 1 à 4, dans lequel le creuset est en nitrure de bore.

FIG. 1

FIG. 2

FIG. 3

FIG. 4

FIG. 5

50